# EUROPÄISCHE PATENTSCHRIFT

(11) **EP 0 281 941 B1**
(45) Veröffentlichungstag und Bekanntmachung des Hinweises auf die Patenterteilung: **08.12.1993**
(21) Anmeldenummer: 88103267.6
(22) Anmeldetag: 03.03.1988
(51) Int. Cl.: C08F 2/50, G03C 1/72, C09D 123/00

(54) **Coreaktive Fotoinitiatoren**
Coreactive photoinitiators
Photo-initiateurs coréactifs

(30) Priorität: 12.03.1987 DE 3707891; 13.11.1987 DE 3738567
(43) Veröffentlichungstag der Anmeldung: 14.09.1988
(73) Patentinhaber: CIBA-GEIGY AG, 4002 Basel (CH)
(72) Erfinder: Köhler, Manfred, Dr., D-6100 Darmstadt (DE); Ohngemach, Jörg, Dr., D-6107 Reinheim (DE); Poetsch, Eike, Dr., D-6109 Mühltal 6 (DE); Eidenschink, Rudolf, Dr., D-6109 Mühltal 1 (DE); Greber, Gerhard, Prof. Dr., A-2540 Bad Vöslau (AT); Dorsch, Dieter, Dr., D-6100 Darmstadt (DE); Gehlhaus, Jürgen, Dr., D-6147 Lautertal (DE); Dorfner, Konrad, Dr., D-6100 Darmstadt (DE); Hirsch, Hans-Ludwig, Dr., D-6107 Reinheim 5 (DE)

(56) Entgegenhaltungen:
- EP-A- 0 005 530
- EP-A- 0 110 831
- EP-A- 0 143 201
- EP-A- 0 246 848
- DE-A- 2 818 763
- DE-A- 3 512 179
- DE-A- 3 534 645
- US-A- 3 429 852
- US-A- 4 077 806
- US-A- 4 348 530
- US-A- 4 459 416
- US-A- 4 496 447
- US-A- 4 576 975
- US-A- 4 582 862
- US-A- 4 602 097

## Beschreibung

Die Erfindung betrifft coreaktive Fotoinitiatoren für die Fotopolymerisation ethylenisch ungesättigte Verbindungen enthaltender Systeme.

Fotochemisch induzierte Polymerisationsreaktionen haben in der Technik große Bedeutung erlangt, insbesondere wenn es um eine schnelle Härtung von dünnen Schichten geht, wie z. B. bei der Härtung von Lack- und Harzüberzügen auf Papier, Metall und Kunststoff oder bei der Trocknung von Druckfarben, da diese Verfahren sich gegenüber konventionellen Methoden zum Bedrucken und Beschichten von Gegenständen durch Rohstoff- und Energieersparnis und eine geringere Umweltbelastung auszeichnen. Aber auch die Herstellung von Polymermaterialien an sich durch Polymerisation entsprechender ungesättigter monomerer Ausgangsmaterialien erfolgt vielfach fotochemisch, wobei übliche Verfahren wie Lösungs- und Emulsionspolymerisationen zur Anwendung gelangen können.

Da bei den genannten Reaktionen in der Regel keiner der Reaktionspartner in der Lage ist, die fotochemisch wirksame Strahlung in ausreichendem Maße zu absorbieren, müssen sogenannte Fotoinitiatoren zugesetzt werden, die in der Lage sind, entweder eingestrahlte energiereiche Strahlung, meist UV-Licht, zu absorbieren und dabei aktive Starterradikale zu bilden, die ihrerseits die Fotopolymerisation auslösen, oder die aufgenommene Energie zur Radikalbildung auf einen der polymerisierbaren Reaktionspartner zu übertragen. An der eigentlichen Polymerisationsreaktion nehmen die Initiatoren normalerweise nicht teil.

Als Initiatoren für die Fotopolymerisation ungesättigter Verbindungen sind bisher hauptsächlich Benzophenonderivate, Benzoinether, Benzilketale, Dibenzosuberonderivate, Anthrachinone, Xanthone, Thioxanthone, α-Halogenacetophenonderivate, Dialkoxyacetophenone und Hydroxyalkylphenone eingesetzt worden.

Die technische Anwendbarkeit vieler der genannten Substanzen wird jedoch bekanntermaßen durch eine Reihe von Nachteilen zum Teil deutlich eingeschränkt. Hierzu gehört insbesondere eine häufig nicht zufriedenstellende Reaktivität im Vermögen, die Fotopolymerisation ethylenisch ungesättigter Verbindungen zu initiieren. Neben molekülspezifischer Reaktivität spielt hierbei vielfach die Löslichkeit bzw. die möglichst gleichmäßige Einarbeitbarkeit der Fotoinitiatoren in den fotopolymerisierbaren Systemen eine entscheidende Rolle.

Weitere Probleme sind die Dunkellagerstabilität der mit den Fotoinitiatoren versetzten Systeme sowie die mögliche Beeinflussung der Endprodukte durch Reste oder Abbauprodukte des Fotoinitiators. Derartige Reste können, je nach Art und Anteil, zu mehr oder weniger ausgeprägten Beeinflussungen der Produkteigenschaften führen. Bei fotopolymerisierten Lackbeschichtungen, dem Hauptanwendungsgebiet für Fotoinitiatoren beispielsweise, können derartige Reste die erzielbare Endhärte der Schicht beeinflussen; desweiteren kann es, oft auch erst nach längerer Zeit, zu unerwünschten Farbveränderungen, beispielsweise Vergilbung kommen. Initiatorreste oder deren Abbauprodukte können sich aufgrund ihrer mehr oder weniger ausgeprägten Flüchtigkeit durch unangenehmen Geruch bemerkbar machen; ihre Diffusion aus der Beschichtung heraus in umgebende Medien kann Probleme schaffen, beispielsweise wenn mit fotopolymerisierten Beschichtungen versehene Verpackungsmaterialien wie etwa Dosen und Tuben für Lebensmittel vorgesehen sind. Gerade in diesem Anwendungsbereich wird die Frage der Verwendbarkeit entscheidend von der möglichen bzw. erwiesenen Toxizität der Fotoinitiatoren sowie ihrer Abbauprodukte bestimmt.

Ein besonderes Problem vor allem im Hinblick auf eine breite Anwendung von Fotoinitiatoren ist, daß diese naturgemäß nur in solchen Systemen eingesetzt werden können, die im wesentlichen Komponenten mit radikalisch polymerisierbaren olefinischen Doppelbindungen enthalten.

Thermisch härtbare Systeme auf ausschließlicher Basis nicht radikalisch induzierter Polyadditions- oder Polykondensationsreaktionen können nicht durch den Zusatz von radikalbildenden Fotoinitiatoren in strahlungshärtbare Systeme überführt werden. Dementsprechend ist die Materialauswahl an Komponenten für strahlungshärtbare Systeme beschränkt. Viele materialspezifische Eigenschaften thermisch härtbarer Systeme lassen sich in strahlungshärtbaren Systemen nicht oder noch nicht ohne weiteres nutzen. Ein Ausweg bietet sich hier mit sogenannten Hybridbindemittelsystemen, in denen thermisch und fotochemisch härtbare Anteile kombiniert sind und in denen die thermische und die fotochemische Reaktion gleichzeitig oder auch nacheinander ablaufen kann. Bei der Entwicklung derartiger Systeme gibt es aber vielfach Kompatibilitätsprobleme, insbesondere im Hinblick auf die einzusetzenden Fotoinitiatoren. In der Fachwelt bestand somit weiterhin ein besonderes Bedürfnis nach Fotoinitiatoren, die neben vorzüglichen Initiatoreigenschaften und guter Dunkellagerstabilität der damit versetzten Systeme eine breite Einsatzfähigkeit auch in komplex zusammengesetzten Systemen besitzen und sich selbst bzw. ihre Fotolyseprodukte migrationsfest in solche Systeme einbinden lassen.

Einzelne Schritte in diese Richtung sind schon unternommen worden. So beschreiben etwa die DE-OS 35 34 645 und die EP-OS 161463 Fotoinitiatoren vom Hydroxyalkylphenon-Typ, die spezielle olefinisch ungesättigte Substituenten tragen. Diese Initiatoren bzw. ihre Fotolyseprodukte können durch Copolymerisation mit den Bestandteilen des strahlungshärtbaren Systems in den Polymerverband eingebunden werden. Sie können auch selbst zunächst thermisch polymerisiert werden und dann als polymerer und damit migrationsfester Fotoinitiator in das strahlungshärtbare System eingebracht werden. Diese speziellen copolymerisierbaren bzw. polymeren Fotoinitiatoren haben jedoch nur eine beschränkte Einsatzbreite.

Der Erfindung lag somit die Problemstellung zugrunde, Fotoinitiatoren aufzufinden und bereitzustellen, die möglichst so strukturiert sein sollten, daß sie neben der Fähigkeit, durch Strahlungseinwirkung die Polymerisation von ethylenisch ungesättigten Verbindungen zu initiieren, noch die Eigenschaft besitzen, mit beliebigen Bestandteilen strahlungshärtbarer Systeme, unabhängig davon, ob diese nun an der Fotopolymerisationsreaktion teilnehmen oder nicht, zu reagieren, mit dem Ziel, einer festen Einbindung in den resultierenden Polymerverband.

Es wurde nun gefunden, daß dies in hervorragender Weise von Verbindungen der allgemeinen Formel I,

RG-A-IN (I)

worin
- IN: für die Formel 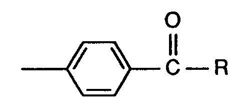 steht, worin
- R: -CR³R⁴R⁵ ist,
- R³, R⁴: unabhängig voneinander H,C₁-C₁₂-Alkyl,C₁-C₁₂-Alkoxy oder Phenyl bedeuten oder zusammen C₂-C₆-Alkylen bilden,
- R⁵: für OR⁷ steht,
- R⁷: H oder C₁-C₆-Alkyl ist,
- A: eine Spacergruppe Z[(CH₂)ₒY]ₙ-[(CH₂)ₘX]ₗ darstellt, worin
- X: -O- ist,
- Y: -O-, -NH- oder -O-CO-bedeutet,
- Z: für eine Einfachbindung, -NH-, -NH-CO- oder -CO-NH- steht,
- l: 1 ist,
- m: eine Zahl von 1 bis 4 bedeutet,
- o: eine Zahl von 0 bis 4 bedeutet,
- n: 1 ist, falls Y -O-CO-ist und n eine Zahl von 0 bis 4 ist, falls Y -O- oder -NH- ist und
- RG: für eine der funktionellen reaktiven Gruppen Oxiranyl, O=C=N-, S=C=N-, N₃-, R^{c}R^{b}C=CR^{a}-, 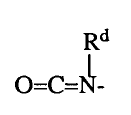 oder (R^{e})₃Si steht, und im Falle, daß Z und/oder Y -NH- sind, RG außerdem OH oder NH₂ bedeutet,
- R^{a}, R^{b} und R^{c}: unabhängig voneinander H oder CH₃ sind,
- R^{d}: C₁-C₆-Alkylen oder Phenylen bedeutet und
- R^{e}: C₁-C₁₂-Alkoxy ist,
erfüllt wird.

Die Verbindungen der Formel I sind neu. Es sind dies hochreaktive Fotoinitiatoren, die unabhängig von ihrer Fotoreaktivität nicht fotochemisch induzierte (Co)-Reaktionen eingehen können und deshalb als coreaktive Fotoinitiatoren bezeichnet werden sollen.

Als Coreaktionen im Sinne der Erfindung sind alle solche Reaktionen zu verstehen, die die Fotoinitiatoren bzw. ihre Fotolyseprodukte mit Bestandteilen strahlungshärtbarer Systeme, mit sich selbst oder auch mit dem Substrat, auf das diese oder ein entsprechendes strahlungshärtbares System als Lack oder Beschichtung aufgebracht wird, eingehen und die eine ortsfeste Bindung der Fotoinitiatoren bzw. ihrer Abbauprodukte bewirken. Bei diesen Coreaktionen handelt es sich in erster Linie um solche Reaktionen, bei denen kovalente chemische Bindungen geknüpft werden. Es kommen aber auch solche Reaktionen in Betracht, bei denen die fixierende Wirkung auf anderen Wechselwirkungen, wie etwa ionischen oder polaren Wechselwirkungen, beruht.

Der besondere Vorteil der erfindungsgemäßen Verbindungen gegenüber konventionellen Fotoinitiatoren ergibt sich aus der Anwesenheit der über die Spacer-Gruppierung A verknüpften reaktiven Gruppe RG, die diesen zusätzlich zur spezifischen Fotoreaktivität die Möglichkeit, nicht fotochemische Reaktionen einzugehen, verleiht. Die Vielfalt an reaktiven Gruppen läßt eine maßgeschneiderte Anpassung an die unterschiedlichsten Anwendungen zu. Die Coreaktion kann unabhängig von der eigentlichen Fotoreaktion vor, während oder nach dieser erfolgen.

Dies führt überraschenderweise zu einem unerwartet hohen Maß an Einbau der unumgesetzten Fotoinitiatoren bzw. der Fotoinitiatorabbauprodukte in das letztendlich erhaltene Polymerprodukt. Hierdurch lassen sich sehr wirksam unerwünschte Einflüsse auf die Eigenschaften des Endproduktes vermindern bzw. gänzlich eliminieren.

Weiterhin bietet die Fixierung von Fotoinitiatoren direkt auf dem Substrat oder in Form einer Schicht von oligomeren, polymeren oder copolymerisierten Fotoinitiatoren eine bessere Verankerung darauf aufgebrachter fotopolymerisierbarer Beschichtungen mit dem Substrat oder bessere Schichthärtung aufgrund lokal besonders hoher Initiatorkonzentrationen. Gerade in dieser Anwendung lassen sich interessante Effekte und neue Eigenschaften erzielen.

Viele Verbindungen der Formel I sind darüberhinaus wertvolle Synthesezwischenprodukte auf dem Weg zu weiterfunktionalisierten Fotoinitiatoren oder strahlungsreaktiven Systemen mit kovalent eingebundenem Fotoinitiator.

Gegenstand der Erfindung ist somit die Verwendung der Verbindungen der Formel I als coreaktive Fotoinitiatoren für die Fotopolymerisation ethylenisch ungesättigte Verbindungen enthaltender Systeme, insbesondere bei der Strahlungshärtung von Beschichtungen mit UV-härtbaren Lack- und Bindemittelsystemen, vor allem auch Hybridbindemittelsystemen.

Gegenstand der Erfindung sind auch Verbindungen der Formel I an sich.

Gegenstand der Erfindung ist weiterhin ein Verfahren zur Fotopolymerisation ethylenisch ungesättigte Verbindungen enthaltender Systeme, wobei man dem zu polymerisierenden Gemisch vor der Auslösung der Fotopolymerisation mindestens eine Verbindung der Formel I als coreaktiven Fotoinititator zusetzt.

Gegenstand der Erfindung sind darüberhinaus fotopolymerisierbare Systeme, enthaltend mindestens eine ethylenisch ungesättigte fotopolymerisierbare Verbindung sowie gegebenenfalls weitere bekannte und übliche Zusatzstoffe, wobei diese mindestens eine Verbindung der Formel I als coreaktiven Fotoinitiator enthalten.

Gegenstand der Erfindung ist schließlich die Verwendung von Verbindungen der Formel I als Synthesezwischenprodukte bei der Herstellung von weiterfunktionalisierten Fotoinitiatoren sowie von strahlungsreaktiven Systemen mit kovalent eingebundenem Fotinitiator.

Die Verbindungen der Formel I leiten sich strukturell von bekannten Fotoinitiatoren ab. In Formel I steht IN für eine Fotoinitiatorenstruktur, die über eine Spacergruppe A mit einer funktionellen reaktiven Gruppe RG verknüpft ist.

In den Verbindungen der Formel I vereinigen sich somit Fotoinitiatoreigenschaften des Strukturteils IN mit nicht fotochemisch induzierter Reaktivität, also Corektivität, des Strukurteils RG.

IN steht für die aromatische Ketonstruktureinheit 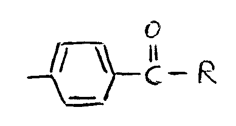
wie sie in praktisch allen klassischen Fotoinitiatoren vorliegt.

R steht für die Gruppierung -CR³R⁴R⁵, und es ergeben sich gemäß den oben angegebenen Definitionen für R³ , R⁴ und R⁵ die Fotoinitiatorgrundstrukuren der Benzoin- und Acyloinether, der Benzilketale und Dialkoxyacetophenone und der Hydroxyalkylphenone.

Coreaktive Hydroxyalkylphenonderivate sind besonders bevorzugte Fotoinitiatoren im Sinne der Erfindung.

Die die Fotoinitiatorgrundstruktur IN mit der reaktiven funktionellen Gruppe RG verknüpfenden Spacergruppe A hat die Struktur Z[(CH₂)ₒY]ₙ-[(CH₂)ₘX]ₗ.

Im einfachsten Fall, wenn Z eine Einfachbindung darstellt, ist die Spacergruppe eine Alkylenbrücke. Die Verknüpfung dieser Alkylengruppe mit dem aromatischen Ring des Fotoinitiatorgrundkörpers erfolgt über ein Heteroatom, weil X für -O- steht.

Die Alkylenbrücke kann aber auch durch ein oder mehrere Heteroatome unterbrochen sein, was dann der Fall ist, wenn Y für -O- oder -NH- steht. Auch sind Unterbrechungen der Alkylenbrücke durch Carbonyl-, Carboxyl-, Carbonsäureamid- oder Urethangruppen möglich. So können beispielsweise als Spacer eine oder mehrere Oxy- oder Aminoalkylengruppen fungieren, vorzugsweise Oxyethylen. Gemischte Heteroalkylenbrücken, sind ebenfalls möglich. Je nach der chemischen Natur der funktionellen reaktiven Gruppe RG ist die Verknüpfung dieser mit der Spacergruppe gemäß den Definitionen für Z eine Einfachbindung, -NH- oder eine Carbonsäureamid- bzw. Urethangruppe.

Als reaktive Gruppen RG kommen alle funktionellen Gruppen in Frage, die leicht nicht-fotochemisch induzierte Reaktionen eingehen können. Ziel einer jeden solchen Reaktion ist eine ortsfeste Einbindung des Fotoinitiators bzw. seiner Fotolyseprodukte in das System. Solche Reaktionen können beispielsweise sein nucleophile Substitutionen durch oder umgekehrt an der Gruppe RG wie etwa Veresterung, Etherbildung oder Säureamidbildung. Die Isocyanat-Gruppe ist eine besonders bevorzugte Gruppe RG, weil sich diese sehr leicht mit Komponenten des Systems umsetzen läßt, die funktionelle Gruppen mit aciden H-Atomen aufweisen.

Als reaktive Gruppen RG sind ebenfalls solche bevorzugt, die thermisch initiierte radikalische oder ionische Polymerisations-, Polyadditions- oder Polykondensationsreaktionen eingehen können. Hierzu gehören die Vinylgruppe und ihre ein- oder mehrfach methylierten Analoga sowie die Oxiranylgruppe. Isocyanatfunktionalisierte C₁₋₆-Alkyl- bzw. Phenylgruppen sind Beispiele für polyadditionsfähige Gruppen. Insertionsreaktionen in beliebige Komponenten des Systems können durch Erzeugung von Carbenen oder Radikalen bewerkstelligt werden, beispielsweise mit der Azidgruppe als reaktive Gruppe RG. Die Silylgruppe bietet neben der Polysiloxanbildung insbesondere die Möglichkeit einer kovalenten Verknüpfung mit dem Substrat, vornehmlich dann, wenn dieses anorganischer Natur ist, wie etwa Glas, Keramik, Metall. Gemäß den angegebenen Definitionen für Fotoinitiatorgrundstruktur IN, Spacer A und reaktive Gruppe RG lassen sich durch Kombination zahlreiche coreaktive Fotoinitiatoren mit für die unterschiedlichsten Anwendungen und Einsatzzwecke maßgeschneiderten Eigenschaften realisieren.

Die Verbindungen der allgemeinen Formel I können nach Standardverfahren der organischen Chemie hergestellt werden. Die Reaktionsbedingungen hierbei können den Standardwerken der präparativen organischen Chemie entnommen werden, z. B. HOUBEN-WEYL, Methoden der organischen Chemie, Georg-Thieme Verlag, Stuttgart, oder ORGANIC SYNTHESIS, J. Wiley, New York London Sydney.

Generell ist es günstig, die erfindungsgemäßen Fotoinitiatoren oder deren Vorstufen nach den bewährten Synthesemethoden, wie sie für die bekannten Fotoinitiatoren gängig sind, herzustellen.

Hierbei ist es vorteilhaft, gleich von den bekannten Fotoinitiatoren als Ausgangssubstanzen auszugehen und an diese mit gängigen Reaktionen, wie Substitutionsreaktionen, in ein oder mehreren Schritten die Spacergruppe A und die reaktive Gruppe RG anzuknüpfen. Es können aber auch schon geeignet substituierte Vorstufen der bekannten Fotoinitiatoren genommen werden und in diese erst, wenn Spacer und reaktive Gruppen schon vorliegen, die eigentliche Fotoinitiator-Wirkstruktur erzeugt werden.

Die Verbindungen der allgemeinen Formel I können erfindungsgemäß als Fotoinitiatoren für die Fotopolymerisation ethylenisch ungesättigter Verbindungen bzw. für die Härtung fotopolymerisierbarer Systeme, die solche Verbindungen enthalten, und insbesondere auch als UV-Härter für Lackbeschichtungen, UV-härtbare Bindemittel- und Hybridbindemittelsysteme, Druckfarben und bei der Strahlungshärtung wäßriger Prepolymerdispersionen verwendet werden. Diese Verwendung erfolgt in üblicher Weise. Die erfindungsgemäß anzuwendenden Verbindungen werden den zu polymerisierenden Systemen in der Regel in Mengen von 0,1 bis 20 Gew.%, vorzugsweise 0,5 bis 12 Gew.% zugesetzt.

Dieser Zusatz geschieht in der Regel durch einfaches Lösen und Einrühren, da die meisten der erfindungsgemäß zu verwendenden Fotoinitiatoren flüssig oder in den zu polymerisierenden Systemen zumindest gut löslich sind. Unter einem zu polymerisierenden System wird ein Gemisch von durch freie Radikale initiierbaren mono- oder polyfunktionellen ethylenisch ungesättigten Monomeren, Oligomeren, Prepolymeren, Polymeren oder Mischungen dieser Oligomeren, Prepolymeren und Polymeren mit ungesättigten Monomeren verstanden, das, falls erforderlich oder erwünscht, weitere Zusätze wie z. B. Antioxidantien, Lichtstabilisatoren, Farbstoffe, Pigmente, aber auch weitere bekannte Fotoinitiatoren sowie Reaktionsbeschleuniger enthalten kann. Als ungesättigte Verbindungen kommen alle diejenigen infrage, deren C=C-Doppelbindungen durch z. B. Halogenatome, Carbonyl-, Cyano-, Carboxy-, Ester-, Amid-, Ether- oder Arylgruppen oder durch konjugierte weitere Doppel- oder Dreifachbindungen aktiviert sind. Beispiele für solche Verbindungen sind Vinylchlorid, Vinylidenchlorid, Acrylnitril, Methacrylnitril, Acrylamid, Methacrylamid, Methyl-, Ethyl-, n-oder tert. Butyl-, Cyclohexyl-, 2-Ethylhexyl-, Benzyl-, Phenyloxyethyl-, Hydroxyethyl-, Hydroxypropyl-, niederes Alkoxyethyl-, Tetrahydrofurfurylacrylat oder -methacrylat, Vinylacetat, -propionat, -acrylat, -succinat, N-Vinylpyrrolidon, N-Vinylcarbazol, Styrol, Divinylbenzol, substituierte Styrole, sowie die Mischungen von solchen ungesättigten Verbindungen. Auch mehrfach ungesättigte Verbindungen wie beispielsweise Ethylendiacrylat, 1,6-Hexandioldiacrylat, propoxyliertes Bisphenol-A-diacrylat und -dimethacrylat, Trimethylolpropandiacrylat und Pentaerythrittriacrylat können mit den erfindungsgemäß verwendeten Fotoinitiatoren polymerisiert werden. Als fotopolymerisierbare Verbindungen kommen weiterhin ungesättigte Oligomere, Prepolymere oder Polymere und deren Mischungen mit ungesättigten Monomeren in Frage. Hierzu zählen beispielsweise ungesättigte Polyester, ungesättigte Acrylmaterialien, Epoximaterialien, Urethane, Silikone, Aminopolyamid-Harze und insbesondere acrylierte Harze wie acryliertes Silikonöl, acrylierte Polyester, acrylierte Urethane, acrylierte Polyamide, acryliertes Sojabohnenöl, acryliertes Epoxiharz, acryliertes Acrylharz, zweckmäßig im Gemisch mit einem oder mehreren Acrylaten eines Mono-, Di- oder Polyalkohols.

Die fotopolymerisierbaren Verbindungen oder Systeme können durch den Zusatz bekannter thermischer Inhibitoren und Antioxidantien, wie beispielsweise Hydrochinon oder Hydrochinonderivate, Pyrogallol, Thiophenole, Nitroverbindungen, β-Naphthylamine oder β-Naphthole in den üblichen Mengen stabilisiert werden, ohne daß dadurch die Initiatorwirkung der erfindungsgemäßen Fotoinitiatoren nennenswert beeinträchtigt wird. Durch solche Zusätze soll vor allem eine vorzeitige Polymerisation während der Herstellung der Systeme durch Mischen der Komponenten verhindert werden.

Weiterhin können geringe Mengen von Lichtstabilisatoren, wie beispielsweise Benzophenon-Derivate, Benzotriazol-Derivate, Tetraalkylpiperidine oder Phenylsalicylate, zugesetzt werden.

Um die inhibierende Wirkung des Luftsauerstoffs auszuschließen, setzt man fotopolymerisierbaren Systemen häufig auch Paraffin oder ähnliche wachsartige Stoffe zu. Infolge mangelnder Löslichkeit im Polymeren schwimmen diese bei Beginn der Polymerisation aus und bilden eine transparente Oberflächenschicht, die den Zutritt von Luft verhindert. Der Luftsauerstoff kann beispielsweise auch durch Einführung von autoxidablen Gruppen, wie z. B. Allylgruppen, in das zu härtende System desaktiviert werden.

Die erfindungsgemäßen Fotoinitiatoren können auch in Kombination mit bekannten radikalischen Initiatoren, wie beispielsweise Peroxiden, Hydroperoxiden, Ketonperoxiden oder Percarbonsäureestern verwendet werden. Weiterhin können sie Pigmente oder Farbstoffe, wie sie z. B. in fotochemisch aushärtenden Druckfarben gebräuchlich sind, enthalten. In diesem Fall wird die Fotoinitiatormenge höher gewählt, beispielsweise 6 bis 12 Gew.%, während für farblose fotopolymerisierbare Produkte 0,1 bis 5 Gew.% in den meisten Fällen voll ausreichen. Je nach Verwendungszweck können Füllstoffe, wie Talkum, Gips oder Kieselsäure, Fasern, organische Zusatzstoffe wie Thixotropiemittel, Verlaufsmittel, Bindemittel, Gleitmittel, Mattierungsmittel, Weichmacher, Netzmittel, Silikone zur Verbesserung der Oberflächenbeschaffenheit, Antiausschwimmittel oder untergeordnete Mengen an Lösungsmitteln zugesetzt werden.

Als gegebenenfalls zusammen mit den erfindungsgemäßen Initiatoren verwendbare bekannte Fotoinitiatoren kommen beispielsweise infrage Benzophenone wie z. B. Michlers Keton [4,4'-Bis(dimethylamino)benzophenon], 4,4'-Bis(diäthylamino)benzophenon, p-Dimethylaminobenzophenon, p-Chlorbenzophenon, Benzophenon; Anthrachinone wie z. B. Anthrachinon, 2-Chloranthrachinon, 2-Alkylanthrachinone; Xanthone wie z. B. 2-Halogenxanthone oder 2-Alkylxanthone; Thioxanthone wie 2-Chlorthioxanthon, 2-Alkylthioxanthone; Acridanone wie z. B. 2-Alkylacridanone oder N-substituierte Acridanone; Benzoine wie z. B. p-Dimethylaminobenzoin und Alkylether des Benzoins; Benzilketale, α-Halogenketone, Dialkoxyacetophenone, α-Hydroxyalkylphenone und α-Aminoalkylphenone wie sie beispielsweise in der DE-OS 27 22 264 und in der EP-OS 3002 beschrieben sind, weiterhin z. B. Fluorenone, Dibenzosuberone, Phenanthrenchinone, Benzoesäureester wie z. B. Hydroxypropylbenzoat, Benzoylbenzoatacrylat. Gemische mit bekannten Initatoren enthalten die erfindungsgemäß anzuwendenden coreaktiven Fotoinitiatoren in der Regel in Anteilen von mindestens 10 Gew.%, vorteilhafterweise von 50 bis 95 Gew.%, bezogen auf die Gesamtmenge an eingesetzter Initiatormischung.

Es ist vorteilhaft, neben den erfindungsgemäßen Fotoinitiatoren in den fotopolymerisierbaren Systemen Reaktionsbeschleuniger einzusetzen. Als solche können beispielsweise organische Amine, Phosphine, Alkohole und/oder Thiole, die alle mindestens eine zum Heteroatom α-ständige CH-Gruppe aufweisen, zugesetzt werden. Geeignet sind z. B. primäre, sekundäre und tertiäre aliphatische, aromatische, araliphatische oder heterocyclische Amine, wie sie z. B. in der US-PS 3,759,807 beschrieben sind. Beispiele für solche Amine sind Butylamin, Dibutylamin, Tributylamin, Cyclohexylamin, Benzyldimethylamin, Di-cyclohexylamin, Triethanolamin, N-Methyldiethanolamin, Phenyl-diethanolamin, Piperidin, Piperazin, Morpholin, Pyridin, Chinolin, p-Dimethylaminobenzoesäureethylester, p-Dimethylaminobenzoesäurebutylester, 4,4ʹ-Bis(dimethylamino)benzophenon (Michlers Keton) oder 4,4ʹ-Bis(diethylamino)benzophenon. Besonders bevorzugt sind tertiäre Amine wie beispielsweise Trimethylamin, Tri-isopropylamin, Tributylamin, Octyl-dimethylamin, Dodecyl-dimethylamin, Triethanolamin, N-Methyl-diethanolamin, N-Butyldiethanolamin, Tris(hydroxypropyl)amin, Dimethylaminobenzoesäurealkylester. Weiterhin kommen als Reaktionsbeschleuniger beispielsweise Trialkylphosphine, sekundäre Alkohole und Thiole in Frage. Der Zusatz derartiger Reaktionsbeschleuniger kann sich in den für sie üblichen Mengen bewegen.

Fotopolymerisierbare Systeme, die zusätzlich als Reaktionsbeschleuniger ein tertiäres organisches Amin enthalten, stellen eine besonders bevorzugte Form der vorliegenden Erfindung dar.

Der Ausdruck "Fotopolymerisation von ethylenisch ungesättigten Verbindungen" ist im weitesten Sinn zu verstehen. Darunter fällt z. B. auch das weitere Polymerisieren oder das Quervernetzen von polymeren Materialien, etwa von Prepolymeren, die Homo-, Co- und Terpolymerisation von einfachen Monomeren und auch die Kombination der genannten Reaktionsarten.

Durch die Einwirkung von energiereicher Strahlung, vorzugsweise UV-Licht, auf die die erfindungsgemäßen coreaktiven Fotoinitiatoren enthaltenden fotopolymerisierbaren Systemen kann die Fotopolymerisation ausgelöst werden. Die Fotopolymerisation erfolgt nach an sich bekannten Methoden durch Bestrahlen mit Licht oder UV-Strahlung des Wellenlängenbereichs von 250-500 nm, vorzugsweise von 300-400 nm. Als Strahlenquellen können Sonnenlicht oder künstliche Strahler verwendet werden. Vorteilhaft sind zum Beispiel Quecksilberdampf-Hochdruck-, -Mitteldruck- oder -Niederdrucklampen sowie Xenon- und Wolframlampen.

Die Durchführung der Fotopolymerisation unter Verwendung der erfindungsgemäßen Fotoinitiatoren kann sowohl diskontinuierlich als auch kontinuierlich geschehen. Die Bestrahlungsdauer hängt von der Art der Durchführung, von der Art und Menge der eingesetzten polymerisierbaren Materialien, von Art und Konzentration der verwendeten Fotoinitiatoren und von der Intensität der Lichtquelle ab und kann, wie beispielsweise bei der Strahlungshärtung von Beschichtungen, im Bereich weniger Sekunden bis Minuten, bei Großansätzen, wie beispielsweise bei der Massepolymerisation, aber auch im Stundenbereich liegen.

Die erfindungsgemäßen Verbindungen der Formel I werden bevorzugt verwendet als Fotoinitiatoren bei der UV-Härtung von dünnen Schichten wie beispielsweise Lackbeschichtungen auf allen hierfür üblichen Materialien und Trägern. Diese können vornehmlich sein Papier, Holz, textile Träger, Kunststoff und Metall. Ein wichtiges Anwendungsgebiet ist auch die Trocknung bzw. Härtung von Druckfarben und Siebdruckmaterialien, von denen letztere bevorzugt bei der Oberflächenbeschichtung bzw. -gestaltung von beispielsweise Dosen, Tuben und metallenen Verschlußkappen eingesetzt werden. Aufgrund der weitestgehenden bis völligen Abwesenheit freier Initiatorreste in mit den erfindungsgemäßen coreaktiven Fotoinitiatoren versetzten Systemen nach erfolgter Fotopolymerisation sind diese besonders geeignet in Anwendungsgebieten, wo eine Diffusion derartiger Reste in entsprechende Endprodukte umgebende Medien ausgeschlossen werden soll, beispielsweise wenn mit fotopolymerisierten Beschichtungen versehene Verpackungsmittel mit Lebensmitteln in Berührung kommen.

Nachfolgend seien die wesentlichen Klassen der erfindungsgemäßen coreaktiven Fotoinitiatoren, typische Vertreter, deren Herstellung sowie bevorzugte Anwendungsweise dargestellt.

Verbindungen der Unterformel II 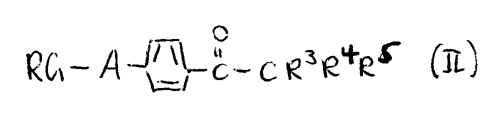
mit den oben angebenen Bedeutungen für die jeweiligen Substituenten repräsentieren im wesentlichen die besonders bevorzugten coreaktiven Fotoinitiatoren vom Hydroxyalkylphenon-Typ (R³ , R⁴ gleich C₁₋₁₂-Alkyl, R⁵ gleich OH), desweiteren coreaktive Derivate von Benzoinethern (R³ gleich Phenyl, R⁴ gleich H, C₁₋₁₂-Alkyl oder Phenyl, R⁵ gleich C₁₋₁₂-Alkoxy), Benzilketalen (R³ gleich Phenyl, R⁴ und R⁵ gleich C₁₋₁₂-Alkoxy) und Dialkoxyacetophenonen (R³ gleich H, C₁₋₁₂-Alkyl, R⁴ und R⁵ gleich C₁₋₁₂-Alkoxy).

Bei der Herstellung der Verbindungen der Formell II kommt neben der Funktionalisierung handelsüblicher oder nach bekannten Methoden hergestellter üblicher Fotoinitiatoren insbesondere bei den bevorzugten Hydroxyalkylphenon--Derivaten der Herstellung aus entsprechend substituierten Vorstufen der zugrunde liegenden Fotoinitiatoren besondere Bedeutung zu, wobei analog zu den hierfür bekannten Methoden vorgegangen wird. Diese Methoden sind beispielsweise ausführlich in der DE-OS 27 22 264 und der EP-OS 3002 beschrieben. Coreaktive Hydroxyalkylphenon-Derivate können etwa aus geeigneten Phenylderivaten, die die Spacergruppierung A und funktionelle Gruppe RG oder entsprechende Vorstufen schon enthalten, in der Weise erhalten werden, daß man zur Einführung der Fotoinitiatorwirkstruktur oder einer Vorstufe hiervon mit einem entsprechenden Carbonsäurehalogenid nach Friedel-Crafts acyliert. Als Ausgangsstoffe geeignete Phenylderivate lassen sich beispielsweise Phenol, Phenylthiol, Phenoxyessigsäure sowie ein- oder mehrfach ethoxyliertes Phenol wie 2-Hydroxyethylphenylether einsetzen. Für die Friedel-Crafts-Acylierung empfiehlt es sich in manchen Fällen, die terminalen funktionellen Gruppen durch geeignete, später wieder entfernbare Schutzgruppen zu schützen, etwa durch Acylierung im Falle der OH-Gruppe. Anilinderivate lassen sich unter Vilsmeier-Bedingungen, z.B. mit Isobuttersäure-N,N-dimethylamid und Phosphoroxichlorid acylieren.

Zur Erzeugung der Fotoinitiatorwirkstruktur des Hydroxyalkylphenontyps kann beispielsweise mit Isobuttersäurehalogenid oder α-Chlorisobuttersäurehalogenid acyliert und anschließend die Hydroxy-, Alkoxy- oder Alkanoyloxygruppierung eingeführt werden. So führt beispielsweise die Friedel-Crafts-Acylierung von acyliertem 2-Hydroxyethylphenylether mit Isobuttersäurechlorid und die anschließende Bromierung und Verseifung am tertiären C-Atom zu der Verbindung 4-(2-Hydroxyethoxy)phenyl-(2-hydroxy-2-propyl)keton. 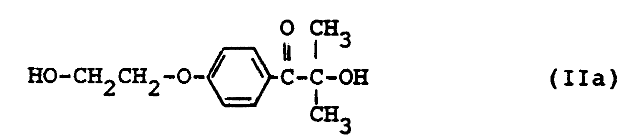
Die Verbindung IIa, die an sich und als Fotoinitiator für wäßrige Systeme bereits in der DE-OS 35 12 179 beschrieben ist, hat hier zentrale Bedeutung, da sie zum einen aufgrund der terminalen OH-Gruppe zur Coreaktivität im Sinne der Erfindung befähigt ist, zum anderen aber auch als Zwischenstufe für eine Vielzahl weiterer, hiervon abgeleiteter coreaktiver Fotoinitiatoren dienen kann, die andere funktionelle Gruppen aufweisen.

Diese Verbindung eignet sich in besonderem Maße auch als coreaktiver Fotoinitiator in Hybrid-Bindemittelsystemen. Derartige Systeme enthalten ganz allgemein zumindest einen thermisch und einen fotochemisch aushärtenden Anteil. Der thermisch härtende Anteil ist normalerweise ein Zwei- oder Mehrkomponenten Reaktionsharz vorzugsweise vom Polyol/Polyisocyanat-Typ. Als fotochemisch härtender Anteil kommen alle hierfür üblichen monomeren, oligomeren oder polymeren ungesättigten Verbindungen und deren Kombinationen in Frage, deren Polymerisation bzw. Vernetzung durch den Einfluß energiereicher Strahlung und mit Hilfe des Fotoinitiators erfolgt. Solche Hybridsysteme lassen sich durch Mischen aller Komponenten erhalten, wobei zweckmäßigerweise die Isocyanatkomponente, wie für Polyurethan-bildende Reaktivharze üblich, erst kurz vor der Anwendung zugegeben wird, um eine vorzeitige Aushärtung des thermisch polymerisierenden Anteils zu vermeiden. Zur Aushärtung von mit derartigen Hybridsystemen hergestellten Beschichtungen werden diese zunächst in für strahlungshärtende Systeme üblicher Weise bestrahlt, wobei eine rasche Oberflächentrocknung und Anhärtung der Schicht erzielt wird. Der endgehärtete Zustand wird nach Ablauf der thermischen Reaktion, die auch durch Wärmezufuhr beschleunigt werden kann, erreicht. Der Vorteil dieser Systeme gegenüber den langsam trocknenden Systemen auf rein thermischer Reaktivharzbasis ist die erhebliche Zeit- und Energieersparnis; die beschichteten Gegenstände sind sofort stapelbar oder schneller weiterverarbeitbar.

Der Vorteil der erfindungsgemäßen coreaktiven Fotoinitiatoren wie Verbindung IIa bei der Anwendung in Hybridbindemittelsystemen ist, daß, im Gegensatz zu konventionellen Fotoinitiatoren, im endgültig ausgehärteten Polymermaterial praktisch keine Fotoinitiatorreste oder Fotolyseprodukte hiervon nachzuweisen sind, wie Extraktionsversuche zeigen. Dementsprechend zeigen de Polymerprodukte eine höhere Endhärte; initiatorbedingte negative Einflüsse wie etwa Geruch oder Vergilbung sind nicht zu verzeichnen. Bedingt durch die coreaktive OH-Gruppe erfolgt ein kovalenter Einbau des erfindungsgemäßen Fotoinitiators in das Polymermaterial durch Reaktion mit äquivalenten Mengen der Isocyanatkomponente des thermisch härtenden Anteils im Hybridbindemittelsystem.

Verbindung IIa läßt sich auch durch Veresterung mit Carbonsäuregruppen-haltigen Komponenten kovalent in sowohl rein strahlungshärtbaren als auch in hybriden Systemen fixieren. Beispiele für solche Komponenten sind etwa Terephthalsäure, Pyromellitsäure bzw. deren Anhydride sowie Oligomere oder Polymere, die sich von diesen Verbindungen ableiten und noch mindestens eine freie Carbonsäurefunktion aufweisen.

Von Verbindung IIa abgeleitete coreaktive Fotoinitiatoren gemäß der Erfindung sind etwa:
4-[2-(Oxiranylmethoxy)ethoxy]-phenyl-(2-hydroxy-2-propyl)keton 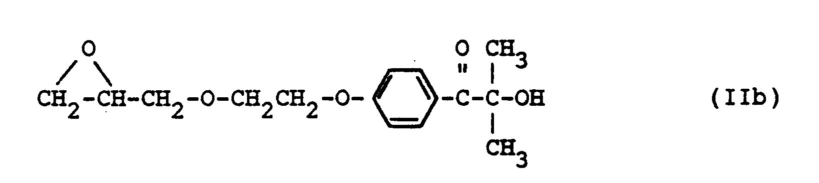
4-(2-Allyloxyethoxy)phenyl-(2-hydroxy-2-propyl)keton 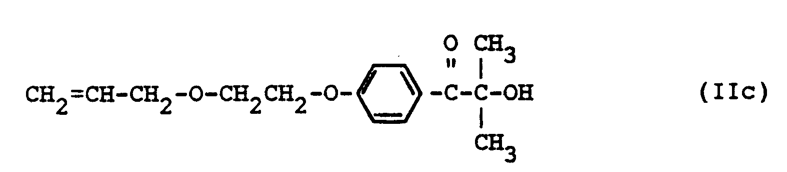
4-[2-(3-Triethoxysilylpropoxy)ethoxy]phenyl-(2-hydroxy-2-propyl)keton 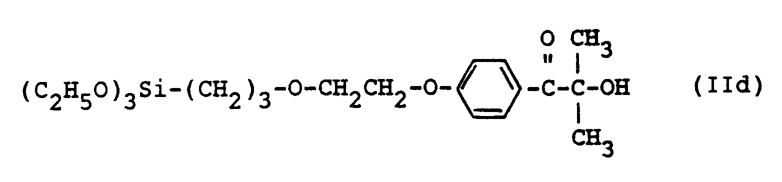
4-(2-Azidoethoxy)phenyl)-(2hydroxy-2-propyl)keton 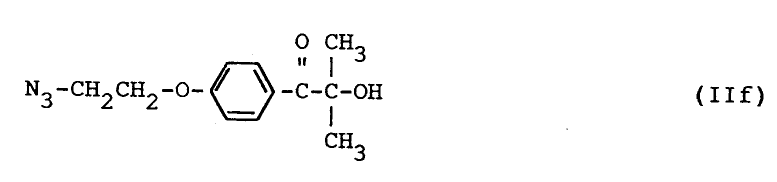
Die Verbindungen IIb und IIc lassen sich aus IIa durch Umsetzung mit Epichlorhydrin bzw. Allylbromid erhalten. Verbindung IId ist aus IIc erhältlich durch anschliessende Umsetzung mit Triethoxysilan.

Verbindung IIf wird durch Umsetzung des p-Toluolsulfonsäureesters von IIa mit Natriumazid erhalten.

Der Epoxy-funktionalisierte Fotoinitiator IIb kann vorteilhaft insbesondere in Hybrid-Bindemittelsystemen eingesetzt werden, deren thermisch härtbarer Anteil ein Reaktivharz vom Epoxid-Typ ist. Aufgrund der Epoxy-Funktion wird IIb bzw. seine Fotolyseprodukte praktisch vollständig in das Epoxidpolymer des Bindemittelsystems eingebunden.

Der ungesättigt funktionalisierte Fotoinitiator IIc ist mit ungesättigten Komponenten beliebiger strahlungshärtbarer Zusammensetzungen copolymerisierbar. Er kann auch selbst thermisch polymerisiert werden. Der resultierende polymere Fotinitiator kann strahlungshärtbaren Zusammensetzungen zugefügt werden, wo er aufgrund seines polymeren Charakters migrationsfest verbleibt. Er kann auch zunächst nur als polymere Initiatorschicht auf ein Substrat aufgebracht werden; eine darüber gezogene fotohärtbare Lackbeschichtung, die keinen weiteren Initiatorzusatz benötigt, kann dann mit vorzüglicher Substrathaftung gehärtet werden.

In analoger Weise kann der Silyl-funktionalisierte Initiator IId eingesetzt werden, wobei seine Anwendung vornehmlich bei der Beschichtung von anorganischen Substraten wie Metallen, Glas oder anderen silikatischen Materialien aufgrund der haftungsverbessernden Silylgruppen Vorteile bringt.

Verbindung IIf ist aufgrund der Azidogruppe hochreaktiv und beispielsweise zu Insertionsreaktionen befähigt.

In analoger Weise herstellbar und anwendbar wie die vorausgegangenen Verbindungen sind die coreaktiven Fotoinitiatoren:
4-Allyloxyphenyl-(2-hydroxy-2-propyl)keton 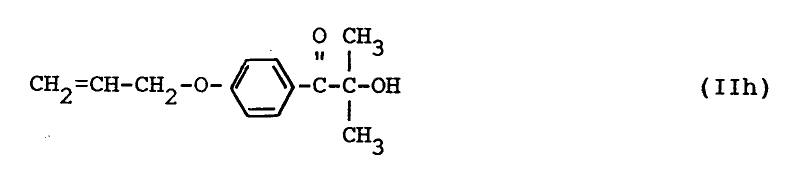
4-Oxiranylmethoxyphenyl-(2-hydroxy-2-propyl)keton 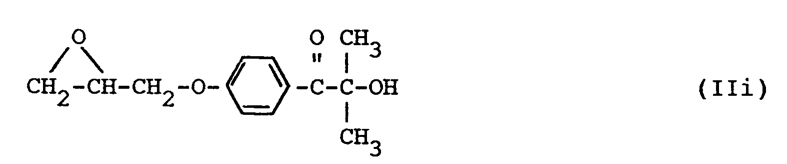
4-[3-(Triethoxysilyl)propoxy]phenyl-(2-hydroxy-2-propyl)keton 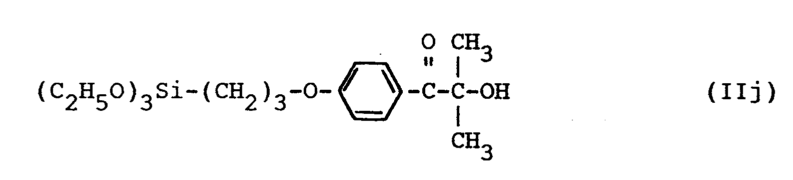
4-(Oxiranylmethoxycarbonylmethoxy)phenyl-(2-hydroxy-2-propyl)keton 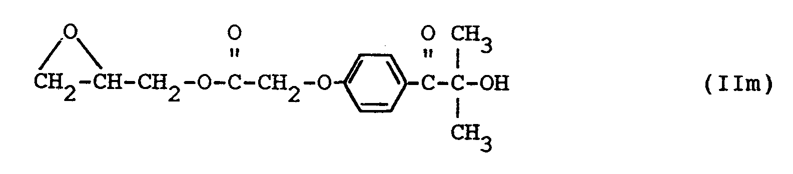
4-Oxiranylmethoxyphenyl-(α-isopropoxybenzyl)keton 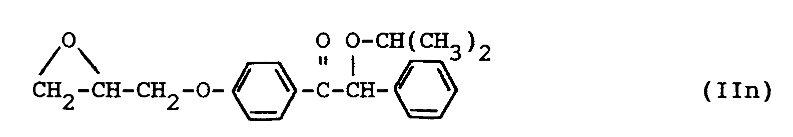
4-[3-(Triethoxysilyl)propoxy]phenyl-(α-isopropoxybenzyl)keton 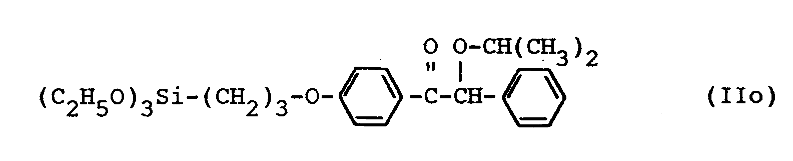
4-Oxiranylmethoxyphenyl-(α,α-dimethoxybenzyl)keton 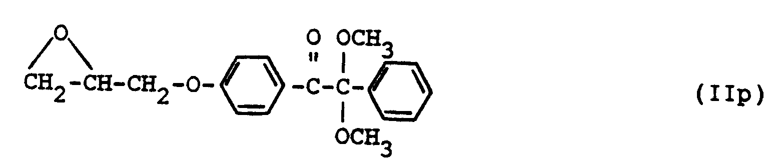
4-[3-(Triethoxysilyl)propoxy]phenyl-(α,α-dimethoxybenzyl)keton 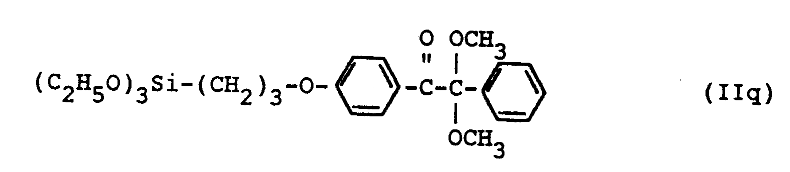
4-(2-Isocyanatoethoxy)phenyl-(2-hydroxy-2-propyl)keton 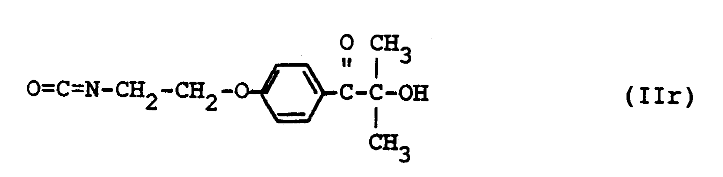
4-(2-Isothiocyanatoethoxy)phenyl-(2-hydroxy-2-propyl)keton 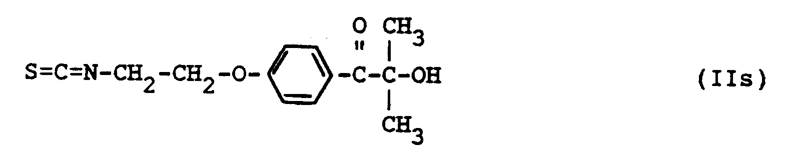
4-(2-Hydroxy-2-methylpropionyl)phenoxyessigsäurehydrazid 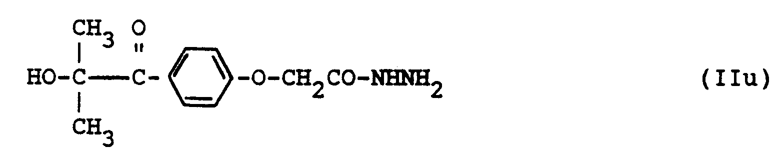
N-[4-(2-Hydroxy-2-methylpropionyl)phenoxyacetyl]hydroxylamin 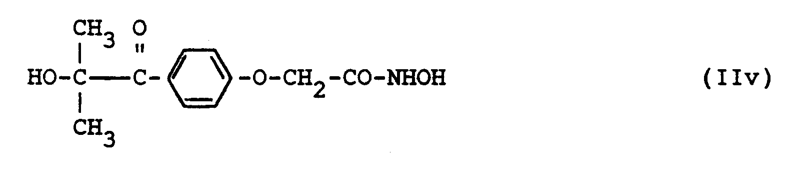
4-Isocyanatomethoxyphenyl-(2-hydroxy-2-propyl)keton 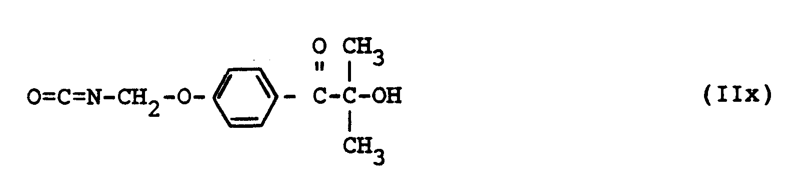
4-(2-Hydroxy-2-methylpropionyl)phenoxyessigsäurevinylester

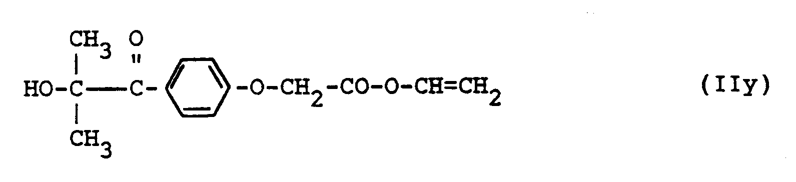

### Beispiel 1

### 4-(2-Hydroxyethoxy)phenyl-(2-hydroxy-2-propyl)keton (IIa)

a) Zu 880 g (8,8 Mol) wasserfreiem Aluminiumchlorid in 480 ml Dichlormethan werden bei -5 bis 0 °C 336 g (3,2 mol) Isobuttersäurechlorid innerhalb von 40 Minuten unter Rühren zugetropft. Danach werden bei der gleichen Temperatur 540 g (3,0 Mol) 2-Phenoxyethylacetat innerhalb von 2 Stunden zugetropft. Man rührt noch weitere 2 Stunden bei der angegebenen Temperatur und gießt die Reaktionsmischung dann in ein Gemisch aus 1,8 l konzentrierter Salzsäure und 5 kg Eis. Die organische Phase wird abgetrennt und die wäßrige Schicht wird mit Dichlormethan extrahiert. Die vereinigten organischen Phasen werden mit Wasser gewaschen, getrocknet, eingeengt und der Rückstand wird im Vakuum destilliert. Man erhält 740 g 4-(2-Acetoxyethoxy)phenyl-2-propylketon mit Siedepunkt 145-152 °C/0,3-0,5 Torr.
b) 205 g (1,0 Mol) 4-(2-Acetoxyethoxy)phenyl-2-propylketon werden in 200 ml Eisessig gelöst und unter Rühren bei 25 °C innerhalb von 2 Stunden mit 192 g (1,2 Mol) Brom versetzt. Es wird ca. 10 Stunden nachgerührt und dann in 3 l Eiswasser eingegossen. Das Produkt wird mit Essigester extrahiert. Die vereinigten Extrakte werden getrocknet und durch Einengen erhält man 365 g eines dickflüssigen Öles. Dieses wird in 1 l Ethanol gelöst und unter Rühren bei 25 °C innerhalb von 20 Minuten mit 380 g 32 %iger Natronlauge versetzt. Es wird 10 Minuten nachgerührt und dann das Ethanol entfernt. Der ölige Rückstand wird in 3 l Eiswasser gegeben, und diese Mischung extrahiert man mehrmals mit insgesamt 1,5 l Essigester. Nach dem Trocknen, Filtrieren und Einengen der Lösung werden 250 g öliges Rohprodukt isoliert. Durch Umkristallisation aus Aceton/Petrolether und/oder chromatographische Aufreinigung erhält man 145 g 4-(2-Hydroxyethoxy)phenyl-(2-hydroxy-2-propyl)keton in Form einer farblosen Festsubstanz vom Schmelzpunkt 88-90 °C.

### Beispiel 2

### 4-(2-Allyloxyethoxy)phenyl-(2-hydroxy-2-propyl)keton (IIc)

Zu einer Mischung von 44,9 g (0,2 mol) IIa und 8,8 g (0,22 mol) granuliertem Natriumhydroxid in 300 ml Toluol werden 26,8 g (0,22 mol) Allylbromid und 1,8 g Methyltrioctylammoniumchlorid als Phasentransferkatalysator gegeben und 20 Stunden bei 50 °C gerührt. Danach wird mit Toluol extrahiert. Übliche Aufarbeitung und chromatographische Reinigung ergeben 28,5 g analysenreine Verbindung IIc.

### Beispiel 3

### 4-[2-(Oxiranylmethoxy)ethoxy]phenyl-(2-hydroxy-2-propyl)keton (IIb)

Durch Umsetzung analog zu Beispiel 2, jedoch mit Epichlorhydrin erhält man Verbindung IIb.

### Beispiel 4

### 4-[2-(3-Triethoxysilylpropoxy)ethoxy]phenyl-(2-hydroxy-2-propyl)keton (IId)

5,3 g (0,02 mol) Verbindung IIc, 4,9 g (0,03 mol) Triethoxysilan und 20 mg Platinkatalysator (Norbornen-Pt-Acetylacetonat-Komplex) in 50 ml Methylenchlorid werden 4 Stunden unter Stickstoff am Rückfluß erhitzt. Nach Einengen und chromatographischer Reinigung des Rückstandes erhält man 3,4 g analysenreine Verbindung IId.

### Beispiel 5

### 4-(Hydroxycarbonylmethoxy)phenyl-(2-hydroxy-2-propyl)keton (IIg)

Analog zu Beispiel 1 erhält man aus 931 g (5,6 mol) Phenoxyessigsäuremethylester durch Friedel-Crafts-Acylierung mit 657 g (6,2 mol) Isobuttersäurechlorid und anschließende Bromierung und Hydrolyse 612 g an Verbindung IIg vom Schmelzpunkt 131-134 °C.

### Beispiel 6

### 4-(2-Hydroxy-2-methylpropionyl)phenoxyessigsäureamid (IIt)

25,2 g (0,1 mol) 4-(2-Hydroxy-2-methylpropionyl)phenoxyessigsäuremethylester (erhalten durch Veresterung von Verbindung IIg mit Methanol) in 50 ml Dioxan werden unter Rühren tropfenweise mit 75,0 g 25%igem Ammoniak versetzt. Nach 2 Stunden Rühren wird bis zur Verfestigung eingeengt. Das Rohprodukt wird aus heißem Wasser umkristallisiert, wobei man 22,1 g an Verbindung IIt vom Schmelzpunkt 139 °C erhält.

### Beispiel 7

### 4-(2-Azidoethoxy)phenyl-(2-hydroxy-2-propyl)keton (IIf)

37,8 g (0,1 mol) 4-(2-p-Tolylsulfonyloxyethoxy)phenyl-(2-hydroxy-2-propyl)keton (erhalten durch Umsetzung von Verbindung IIa mit p-Toluolsulfonsäurechlorid) und 9,8 g (0,15 mol) Natriumazid werden in 100 ml DMSO bei 60 °C eine Stunde gerührt. Durch extraktive Aufarbeitung mit Wasser und Ether bzw. Methyl-t-butylether erhält man 22,4 g an Verbindung IIf als hellgelbes, leicht bewegliches Öl. IR: ν = 2114 cm⁻¹ (N₃).

### Beispiel 8

### 4-Allyloxyphenyl-(2-hydroxy-2-propyl)keton (IIh)

36,0 g (0,2 mol) 4-Hydroxyphenyl-(2-hydroxy-2-propyl)keton werden in 450 ml Dimethylsulfoxid unter Inertgas portionsweise mit 6,6 g (0,22 mol) Natriumhydrid (80%ig in Paraffinöl) versetzt und 15 Minuten bei Raumtemperatur gerührt. Dann werden 26,8 g (0,22 mol) Allylbromid in 40 ml Dimethylsulfoxid bei 30-40 °C zugetropft und 15 Minuten gerührt. Das Reaktionsgemisch wird in 2 l Wasser gegeben und dann mit Methyl-t-butylether extrahiert. Durch Entfernen des Lösungsmittels erhält man 41,5 g an Verbindung IIh.

### Beispiel 9

### 4-Oxiranylmethoxyphenyl-(2-hydroxy-2-propyl)keton (IIi)

Analog zu Beispiel 3 erhält man aus 36,0 g (0,2 mol) 4-Hydroxyphenyl-(2-hydroxy-2-propyl)keton und 19,0 g (0,2 mol) Epichlorhydrin 6,8 g analysenreine Verbindung IIi vom Schmelzpunkt 54 °C.

### Beispiel 10

### 4-[3-(Triethoxysilyl)propoxy]-phenyl-(2-hydroxy-2-propyl)keton (IIj)

Analog zu Beispiel 4 erhält man aus 14,3 g (0,065 mol) II g und 16,0g(0,0975 mol) Triethoxysilan 10,2 g analysenreine Verbindung IIj.

Die nachfolgenden Beispiele 11-13 veranschaulichen die erfindungsgemäße Anwendung der coreaktiven Fotoinitiatoren bei der Strahlungshärtung fotopolymerisierbarer Bindemittelsysteme.

### Beispiele 11

### Hybrid-Bindemittelsystem

Ein Hybrid-Bindemittelsystem, bestehend aus 40,5 Gew.-Teilen eines Hydroxygruppen-haltigen Polyacrylates/ ca. 65 %ig in Butylacetat/Xylol (Desmophen® A 365, Fa. Bayer AG), 17,0 Gew.-Teilen eines aliphatischen Polyisocyanats/ ca. 75 %ig in Methoxypropylacetat/Xylol (Desmodur® N 75, Fa. Bayer AG), 30,0 Gew.-Teilen eines acrylierten Polyurethan-Prepolymeres (VPS 1748, Fa. Degussa AG), 20,0 Gew.-Teilen Hexandioldiacrylat, 7,5 Gew.-Teilen Pentaerythrittriacrylat und 5,0 Gew.-Teilen des Hydroxyfunktionalisierten Fotoinitiators IIa, wurde durch Mischen der Komponente hergestellt, wobei das Polyisocyanat erst kurz vor der Anwendung zugefügt wurde.

Das gebrauchsfertige Hybrid-Bindemittelsystem wurde mit einer Spiralrakel in einer Schichtdicke von 50 µm auf Glasplatten (10 x 10 cm) aufgetragen. Nach einer Ablüftzeit von 5 Minuten wurden die Beschichtungen mit einem UV-Bestrahlungsgerät (Fa. Beltron), bei dem die Platten auf einem Transportband bei Bandgeschwindigkeiten zwischen 2,5 und 40 m/min unter zwei Hg-Mitteldrucklampen von jeweils 50 Watt/cm Leistung in einem Abstand von 10 cm durchgeführt werden, gehärtet.

Bei Bandgeschwindigkeiten zwischen 2,5 und 15 m/min wurden sofort feste Lackbeschichtungen mit trockener Oberfläche erhalten.

Die thermische Nachhärtung der Polyurethan-Reaktivharz-Komponente ergab eine Endhärte der Schichten von:

| | |
|---|---|
| - bei 20 Stunden/Raumtemperatur: | 168 Sekunden |
| - bei 1 Stunde/60 °C: | 188 Sekunden |
| - bei 3 Stunden/60 °C: | 198 Sekunden |
| (Pendelhärte nach König) | |

Nach Extraktion von voll ausgehärtetem Schichtmaterial mit Acetonitril wurde mittels Hochdruckflüssigchromatographie der Anteil an nicht in das Material eingebundenem Initiator zu maximal 3 % der ursprünglich eingesetzten Menge bestimmt.

### Beispiel 12

### UV-härtbares Bindemittelsystem

Ein UV-härtbares Bindemittelsystem, bestehend aus 60 Gew.-Teilen eines acrylierten Polyurethan-Prepolymers (Prepolymer VSP 1748, Fa. Degussa AG), 40 Gew.-Teilen Hexandioldiacrylat, 15 Gew.-Teilen Pentaerythrittriacrylat und 5 Gew.-Teilen des ungesättigt funktionalisierten Fotoinitiators IIc wurde analog zu Beispiel 16 zu 50 µm dicken Beschichtungen verarbeitet und bei einer Bandgeschwindigkeit von 10 m/min gehärtet. Die erhaltenen, voll ausgehärteten Beschichtungen sind völlig geruchfrei und farblos.

In analoger Weise erhält man gleichermaßen gute Ergebnisse mit dem Initiator IIh.

### Beispiel 13

### Schichthärtung mit substratgebundenem Initiator

Eine 25 %ige ethanolische Lösung des Silyl-funktionalisierten Fotoinitiators IId wurde auf Glasplatten (5 x 5 cm) aufgeschleudert und die so behandelten Platten 30 Minuten auf 190 °C erhitzt. Danach wurde mit Aceton abgespült und mit einem Gemisch aus 75 Gew.-Teilen eines acrylierten Epoxid-Prepolymers (Laromer® EA 81, Fa. BASF AG) und 25 Gew.-Teilen Hexandioldiacrylat beschichtet. Nach UV-Härtung bei 3,75 m/min und einer Strahlungsleistung von 120 W/cm und nochmaliger Abspülung mit Aceton wurden harte, sehr fest haftende Beschichtungen einer Dicke von 0,7 - 0,8 µm erhalten.

Entsprechende Ergebnisse erhält man mit dem Initiator IIj.

## Patentansprüche

1. Coreaktive Photoinitiator Verbindungen der Formel (I)
RG-A-IN (I)
worin
IN für die Formel 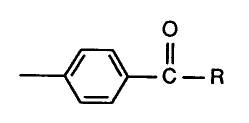 steht, worin
R -CR³R⁴R⁵ ist,
R³, R⁴ unabhängig voneinander H, C₁-C₁₂-Alkyl, C₁-C₁₂-Alkoxy oder Phenyl bedeuten oder zusammen C₂-C₆-Alkylen bilden,
R⁵ für OR⁷ steht,
R⁷ H oder C₁-C₆-Alkyl ist,
A eine Spacergruppe Z[(CH₂)ₒY]ₙ-[(CH₂)ₘX]ₗ darstellt, worin
X -O- ist,
Y -O-, -NH- oder -O-CO- bedeutet,
Z für eine Einfachbindung, -NH-, -NH-CO- oder -CO-NH- steht,
l 1 ist,
m eine Zahl von 1 bis 4 bedeutet,
o eine Zahl von 0 bis 4 bedeutet,
n 1 ist, falls Y -O-CO- ist und n eine Zahl von 0 bis 4 ist, falls Y -O- oder -NH- ist und
RG für eine der funktionellen reaktiven Gruppen Oxiranyl, O=C=N-, S=C=N-, N₃-, R^{c}R^{b}C=CR^{a}-, 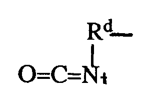 oder (R^{e})₃Si steht, und im Falle, daß Z und/oder Y -NH- sind, RG außerdem OH oder NH₂ bedeutet,
R^{a}, R^{b} und R^{c} unabhängig voneinander H oder CH₃ sind,
R^{d} C₁-C₆-Alkylen oder Phenylen bedeutet und
R^{e} C₁-C₁₂-Alkoxy ist.

2. Verbindungen nach Anspruch 1, worin RG (R^{e})₃Si, und im Falle, daß Z und/oder Y -NH- sind, OH oder NH₂, insbesondere (R^{e})₃Si, bedeutet.

3. Verwendung von Verbindungen der Formel I nach Anspruch 1 als coreaktive Fotoinitiatoren für die Fotopolymerisation ethylenisch ungesättigte Verbindungen enthaltender Systeme.

4. Verwendung von Verbindungen der allgemeinen Formel I nach Anspruch 1 zusammen mit bekannten Fotoinitiatoren und/oder Sensibilisatoren.

5. Verwendung nach Anspruch 3 bei der Strahlungshärtung von Beschichtungen mit UV-härtbaren Lack- und Bindemittelsystemen.

6. Verwendung nach Anspruch 3 bei der Strahlenhärtung von Hybridbindemittelsystemen.

7. Verfahren zur Fotopolymerisation ethylenisch ungesättigte Verbindungen enthaltender Systeme, dadurch gekennzeichnet, daß dem zu polymerisierenden Gemisch vor der Auslösung der Fotopolymerisation mindestens eine Verbindung der Formel I als coreaktiver Fotoinitiator zugesetzt wird.

8. Verfahren nach Anspruch 7, dadurch gekennzeichnet, daß dem zu polymerisierenden Gemisch vor der Auslösung der Fotopolymerisation 0,1 bis 20 Gew.% einer Verbindung der Formel I zugesetzt wird.

9. Verfahren zur Fotopolymerisation ethylenisch ungesättigte Verbindungen enthaltender Systeme, dadurch gekennzeichnet, daß zunächst ein Fotoinitiator der Formel I, worin RG (R^{e})₃Si, bedeutet, auf ein Substrat aufgebracht wird, durch Erwärmen mit der reaktiven Gruppe RG auf diesem Substrat verankert wird, danach das zu polymerisierende ethylenisch ungesättigte Verbindungen enthaltende System aufgebracht und durch Bestrahlen mit Licht oder UV-Strahlung gehärtet wird.

10. Fotopolymerisierbare Systeme, enthaltend mindestens eine ethylenisch ungesättigte fotopolymerisierbare Verbindung sowie gegebenenfalls weitere bekannte und übliche Zusatzstoffe, dadurch gekennzeichnet, daß sie mindestens eine Verbindung der Formel I als coreaktiven Fotoinitiator enthalten.

11. Hybridbindemittelsysteme, dadurch gekennzeichnet, daß sie mindestens eine Verbindung der Formel I als coreaktiven Fotoinitiator enthalten.

12. Fotopolymerisierbare Systeme nach den Ansprüchen 10 und 11, dadurch gekennzeichnet, daß sie 0,1 bis 20 Gew.% einer Verbindung der Formel I enthalten.

13. Verwendung von Verbindungen der Formel I als Synthesezwischenprodukte bei der Herstellung von weiterfunktionalisierten Fotoinitiatoren sowie von strahlungsreaktiven Systemen mit kovalent eingebundenen Fotoinitiatoren.

14. Die Verbindungen der Formel I
4-[2-(Oxiranylmethoxy)ethoxy]phenyl-2-hydroxy-2-propylketon,
4-(2-Allyloxyethoxy)phenyl-2-hydroxy-2-propylketon,
4-[2-(3-Triethoxysilylpropoxy)ethoxy]phenyl-2-hydroxy-2-propylketon,
4-(2-Azidoethoxy)phenyl-2-hydroxy-2-propylketon,
4-Allyloxyphenyl-2-hydroxy-2-propylketon,
4-Oxiranylmethoxyphenyl-2-hydroxy-2-propylketon,
4-[3-(Triethoxysilyl)propoxy]phenyl-2-hydroxy-2-propylketon,
4-(Oxiranylmethoxycarbonylmethoxy)phenyl-2-hydroxy-2-propylketon,
4-Oxiranylmethoxyphenyl-α-isopropoxybenzylketon,
4-[3-(Triethoxysilyl)propoxy]phenyl-α-isopropoxybenzylketon,
4-Oxiranylmethoxyphenyl-α,α-dimethoxybenzylketon,
4-[3-(Triethoxysilyl)propoxy]phenyl-α,α-dimethoxybenzylketon,
4-(2-Isocyanatoethoxy)phenyl-2-hydroxy-2-propylketon,
4-(2-Isothiocyanatoethoxy)phenyl-2-hydroxy-2-propylketon,
4-(2-Hydroxy-2-methylpropionyl)phenoxyessigsäurehydrazid,
N-[4-(2-Hydroxy-2-methylpropionyl)phenoxyacetyl]-hydroxylamin,
4-Isocyanatomethoxyphenyl-2-hydroxy-2-propylketon,
4-(2-Hydroxy-2-methylpropionyl)phenoxyessigsäurevinylester.

15. Verwendung der Verbindung der Formel IIa 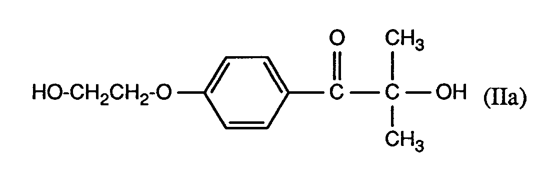 als coreaktiver Fotoinitiator für die Fotopolymerisation ethylenisch ungesättigte Verbindungen enthaltender Systeme, dadurch gekennzeichnet, daß diese Systeme polyisocyanathaltige Hybrid-Bindemittel-Systeme sind.

16. Verfahren zur Polymerisation von polyisocyanathaltigen Hybrid-Bindemittel-Systemen, dadurch gekennzeichnet, daß diesen Systemen ein Fotoinitiator der Formel IIa, gemäß Anspruch 15, zugesetzt wird, die Mischung durch Bestrahlen mit Licht oder UV-Strahlung des Wellenlängenbereichs von 250-500 nm vorgehärtet und durch anschließende thermische Behandlung durchgehärtet wird.

## Claims

1. A coreactive photoinitiator compound of the formula (I)
RG-A-IN (I)
in which
IN is the formula 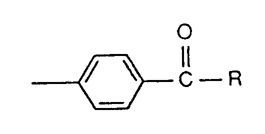 in which
R is -CR³R⁴R⁵,
R³, R⁴ independently of one another are H, C₁-C₁₂alkyl, C₁-C₁₂alkoxy or phenyl, or together form C₂-C₆alkylene,
R⁵ is OR⁷,
R⁷ is H or C₁-C₆alkyl,
A is a spacer group Z[(CH₂)ₒY]ₙ-[(CH₂)ₘX]ₗ
in which
X is -O-,
Y is -O-, -NH- or -O-CO-,
Z is a single bond, -NH-, -NH-CO- or -CO-NH-,
l is 1
m is a number from 1 to 4,
o is a number from 0 to 4,
n is 1 if Y is -O-CO- and n is a number from 0 to 4 if Y is -O-or -NH-, and
RG is one of the functional reactive groups oxiranyl, O=C=N-, S=C=N-, N₃-, R^{c}R^{b}C=CR^{a}-, 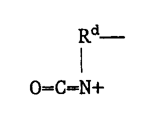 or (R^{e})₃Si, and, if Z and/or Y are -NH-, RG is furthermore OH or NH₂,
R^{a}, R^{b} and R^{c} independently of one another are H or CH₃,
R^{d} is C₁-C₆alkylene or phenylene, and
R^{e} is C₁-C₁₂alkoxy.

2. A compound according to claim 1, in which RG is (R^{e})₃Si and, if Z and/or Y are -NH-, is OH or NH₂, in particular (R^{e})₃Si.

3. The use of a compound of the formula I according to claim 1 as a coreactive photoinitiator for the photopolymerisation of systems comprising ethylenically unsaturated compounds.

4. The use of a compound of the general formula I according to claim 1 together with known photoinitiators and/or sensitizers.

5. The use according to claim 3 in the radiation curing of coatings containing UV-curable paint and binder systems.

6. The use according to claim 3 in the radiation curing of hybrid binder systems.

7. A process for the photopolymerisation of systems comprising ethylenically unsaturated compounds, wherein at least one compound of the formula I is added as a coreactive photoinitiator to the mixture to be polymerised before initiation of the photopolymerisation.

8. A process according to claim 7, wherein 0.1 to 20% by weight of a compound of the formula I are added to the mixture to be polymerised before initiation of the photopolymerisation.

9. A process for the photopolymerisation of systems comprising ethylenically unsaturated compounds, which comprises initially applying a photoinitiator of the formula I in which RG is (R^{e})₃Si to a substrate, anchoring it on this substrate by heating with the reactive group RG, then applying the system comprising ethylenically unsaturated compounds which is to be polymerised and curing it by irradiating with light or UV radiation.

10. A photopolymerisable system comprising at least one ethylenically unsaturated, photopolymerisable compound and, if appropriate, further known and conventional additives, which contains at least one compound of the formula I as a coreactive photoinitiator.

11. A hybrid binder system, which contains at least one compound of the formula I as a coreactive photoinitiator.

12. A photopolymerisable system according to claims 10 and 11, which contains 0.1 to 20% by weight of a compound of the formula I.

13. The use of a compound of the formula I as a synthesis intermediate in the preparation of further-functionalised photoinitators and of radiation-reactive systems having covalently bound photoinitiators.

14. The compounds of the formula I
4-[2-(oxiranylmethoxy)ethoxy]phenyl 2-hydroxy-2-propyl ketone,
4-(2-allyloxyethoxy)phenyl 2-hydroxy-2-propyl ketone,
4-[2-(3-triethoxysilylpropoxy)ethoxy]phenyl 2-hydroxy-2-propyl ketone,
4-(2-azidoethoxy)phenyl 2-hydroxy-2-propyl ketone,
4-allyloxyphenyl 2-hydroxy-2-propyl ketone,
4-oxiranylmethoxyphenyl 2-hydroxy-2-propyl ketone,
4-[3-(triethoxysilyl)propoxy]phenyl 2-hydroxy-2-propyl ketone,
4-(oxiranylmethoxycarbonylmethoxy)phenyl 2-hydroxy-2-propyl ketone,
4-oxiranylmethoxyphenyl α-isopropoxybenzyl ketone,
4-[3-(triethoxysilyl)propoxy]phenyl α-isopropoxybenzyl ketone,
4-oxiranylmethoxyphenyl α,α-dimethoxybenzyl ketone,
4-[3-(triethoxysilyl)propoxy]phenyl α,α-dimethoxybenzyl ketone,
4-(2-isocyanatoethoxy)phenyl 2-hydroxy-2-propyl ketone,
4-(2-isothiocyanatoethoxy)phenyl 2-hydroxy-2-propyl ketone,
4- (2-hydroxy-2-methylpropionyl)phenoxyacetohydrazide,
N-[4-(2-hydroxy-2-methylpropionyl)phenoxyacetyl]-hydroxylamine,
4-isocyanatomethoxyphenyl 2-hydroxy-2-propyl ketone, and vinyl 4-(2 hydroxy-2-methylpropionyl)phenoxyacetate.

15. The use of the compound of the formula IIa 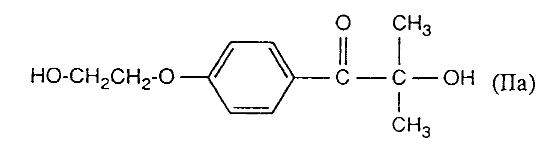 as a coreactive photoinitiator for the photopolymerisation of systems comprising ethylenically unsaturated compounds, wherein these systems are hybrid binder systems containing polyisocyanate.

16. A process for the polymerisation of hybrid binder systems containing polyisocyanate, which comprises adding to these systems a photoinitiator of the formula IIa as in claim 15, precuring the mixture by irradiating with light or UV radiation in the wavelength range from 250-500 nm and curing fully by subsequent thermal treatment.

## Revendications

1. Composés photo-amorceurs co-réactifs de formule (I)
RG-A-IN (I)
dans laquelle
IN représente la formule 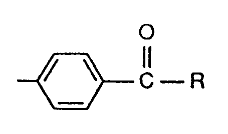 dans laquelle
R est -CR³R⁴R⁵,
R³,R⁴ indépendamment l'un de l'autre, sont chacun H ou un radical alkyle en C₁-C₁₂, alcoxy en C₁-C₁₂ ou phényle, ou forment ensemble un radical alkylène en C₂-C₆,
R⁵ est OR₇,
R⁷ est H ou un radical alkyle en C₁-C₆,
A est un groupe intermédiaire Z[(CH₂)ₒY]ₙ[(CH₂)ₘX]₁, où
X est -O-,
Y -O-, -NH- ou -O-CO-,
Z est une liaison simple, -NH-, -NH-CO- ou -CO-NH-,
l vaut 1,
m est un nombre de 1 à 4,
o est un nombre de 1 à 4,
n vaut 1 si Y est -O-CO-, et n est un nombre de 0 à 4 si Y est -O- ou -NH-, et
RG est l'un des groupes réactifs fonctionnels oxirannyles, O=C=N, S=C=N, N₃-,
R^{c}R^{b}C=CR^{a}-, 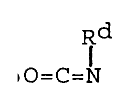 ou (R^{e})₃Si, et, quand Z et/ou Y sont -NH, RG représente en outre OH ou NH₂,
R^{a}, R^{b} et R^{c} représentent chacun indépendamment des autres H ou CH₃,
R^{d} est un groupe alkylène en C₁-C₆ ou phénylène, et
R^{e} est un radical alcoxy en C₁-C₁₂.

2. Composés selon la revendication 1, dans lesquels RG est (R^{e})₃Si et, quand z et/ou Y sont -NH, OH ou NH₂, en particulier (R^{e})₃Si.

3. Utilisation de composés de formule I selon la revendication 1, comme photo-amorceurs co-réactifs pour la photopolymérisation de systèmes contenant des composés à insaturation éthylénique.

4. Utilisation de composés de formule générale I selon la revendication 1, en même temps que de photo-amorceurs et/ou de sensibilisateurs connus.

5. Utilisation selon la revendication 3, lors du durcissement, sous l'effet d'un rayonnement, de revêtements comportant des systèmes de liants et de vernis pouvant durcir sous l'effet des rayons UV.

6. Utilisation selon la revendication 3, lors du durcissement, sous l'effet d'un rayonnement, de systèmes de liants hybrides.

7. Procédé pour photopolymériser des systèmes contenant des composés à insaturation éthylénique, caractérisé en ce qu'on ajoute au mélange à polymériser, avant déclenchement de la photopolymérisation, au moins un composé de formule I servant de photo-amorceur co-réactif.

8. Procédé selon la revendication 7, caractérisé en ce qu'on ajoute au mélange à polymériser, avant le déclenchement de la photopolymérisation, de 0,1 à 20 % en poids d'un composé de formule I.

9. Procédé pour photopolymériser des systèmes contenant des composés à insaturation éthylénique, caractérisé en ce qu'on applique d'abord, sur un substrat, un photoamorceur de formule I dans laquelle RG est (R^{e})₃Si, on l'ancre sur ce substrat, par chauffage avec le groupe réactif RG, puis on applique le système contenant des composés à polymériser, à insaturation éthylénique, et on durcit par exposition à la lumière ou à un rayonnement UV.

10. Systèmes photopolymérisables contenant au moins un composé photopolymérisable à insaturation éthylénique et éventuellement d'autres additifs connus et usuels, caractérisés en ce qu'ils contiennent au moins un composé de formule I servant de photo-amorceur co-réactif.

11. Systèmes de liants hybrides, caractérisés en ce qu'ils contiennent au moins un composant de formule I servant de photo-amorceur co-réactif.

12. Systèmes photopolymérisables selon les revendications 10 et 11, caractérisés en ce qu'ils contiennent de 0,1 à 20 % en poids d'un composé de formule I.

13. Utilisation de composés de formule I en tant que produits intermédiaires de synthèse lors de la préparation de photo-amorceurs présentant une fonctionnalité plus poussée, ainsi que de systèmes réagissant aux rayonnements et comportant des photo-amorceurs fixés par liaison covalente.

14. Les composés de formule I :
4-[2-(oxirannylméthoxy)éthoxy]-phényl-(2-hydroxy-2-propyl)cétone
4-(2-allyloxyéthoxy)phényl-(2-hydroxy-2-propyl)cétone
4-[2-(3-triéthoxysilylpropoxy)éthoxy]phényl-(2-hydroxy-2-propyl) cétone
4-(2-azidoéthoxy)phényl)-(2-hydroxy-2-propyl) cétone
4-allyloxyphényl-(2-hydroxy-2-propyl) cétone
4-oxirannylméthoxyphényl-(2-hydroxy-2-propyl) cétone
4-[3-(triéthoxysilyl)propoxy]phényl-(2-hydroxy-2-propyl) cétone
4-(oxirannylméthoxycarbonylméthoxy) phényl-(2-hydroxy-2-propyl) cétone
4-oxirannylméthoxyphényl-(α-isopropoxybenzyl) cétone
4-[3-(triéthoxysilyl)propoxy]phényl-(α-isopropoxybenzyl) cétone
4-oxirannylméthoxyphényl-(α,α-diméthoxybenzyl) cétone
4-[3-(triéthoxysilyl)propoxy]phényl-(α,α-diméthoxybenzyl) cétone
4-(2-isocyanatoéthoxy)phényl-(2-hydroxy-2-propyl) cétone
4-(2-isothiocyanatoéthoxy)phényl-(2-hydroxy-2-propyl) cétone
Hydrazide 4- (2-hydroxy-2-méthyl-propionyl) phénoxyacétique
N- [4- (2-hydroxy-2-méthylpropionyl)phénoxyacétyl] hydroxylamine
4-isocyanatométhoxyphényl-(2-hydroxy-2-propyl) cétone
4-(2-hydroxy-2-méthylpropionyl)phénoxyacétate de vinyle

15. Utilisation du composé de formule IIa 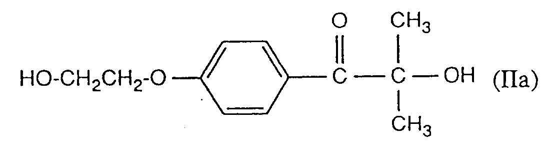 comme photo-amorceur co-réactif pour la photopolymérisation de systèmes contenant des composés à insaturation éthylénique, caractérisés en ce que ces systèmes sont des systèmes de liants hybrides contenant un polyisocyanate.

16. Procédé pour photopolymériser des systèmes de liants hybrides contenant un polyisocyanate, caractérisé en ce qu'on ajoute à ces systèmes un photo-amorceur de formule IIa selon la revendication 15, on procède à un durcissement préalable du mélange par exposition à la lumière ou à un rayonnement UV de longueur d'onde comprise entre 250 et 500 nm, puis on durcit par un traitement thermique.
